# EUROPÄISCHE PATENTANMELDUNG

(11) **EP 1 650 792 A1**
(43) Veröffentlichungstag der Anmeldung: **26.04.2006**
(21) Anmeldenummer: 05015609.0
(22) Anmeldetag: 19.07.2005
(51) Int. Cl.: H01L 21/687, C23C 14/50

(54) **Vorrichtung und Verfahren zum Kühlen plattenförmiger Substrate**

(30) Priorität: 19.10.2004 DE 102004050822
(71) Anmelder: Fraunhofer-Gesellschaft zur Förderung der angewandten Forschung e.V., 80686 München (DE)
(72) Erfinder: Metzner, Christoph Dr, 01328 Dresden (DE); Heinss, Jens-Peter Dr, 01309 Dresden (DE); Weiske, Dieter, 01239 Dresden (DE); Murcek, Petr, 01640 Coswig (DE); Tenbusch, Matthias, 01099 Dresden (DE)

(57) **Zusammenfassung**

Die Erfindung betrifft eine Vorrichtung und ein Verfahren zum Kühlen plattenförmiger Substrate im Vakuum, wobei mindestens eine Kühlfläche einen Kühlkörper (13) begrenzt, erste Mittel (12) mindestens ein plattenförmiges Substrat (11) auf der Kühlfläche des Kühlkörpers (13) derart fixieren, dass die der Kühlfläche zugewandte Seite des Substrates (11) im Wesentlichen parallel zur Kühlfläche verläuft und zweite Mittel ein Fluid in einen Zwischenraum (14) zwischen Kühlfläche und Substrat (11) zuführen, wobei die Form der Kühlfläche derart ausgebildet wird, dass eine im Wesentlichen parallele Anordnung der der Kühlfläche zugewandten Substratseite zur Kühlfläche nur durch eine zumindest teilweise elastische Verformung des Substrates (11) mittels einer auf das Substrat (11) einwirkenden Verformungskraft erreicht wird, die dem Betrag nach mindestens so groß ist, wie die durch den Druck des Fluids im Zwischenraum (14) auf das Substrat (11) einwirkende Kraft.

## Beschreibung

Die Erfindung betrifft eine Vorrichtung und ein Verfahren zum Kühlen plattenförmiger Substrate im Vakuum. Vorrichtung und Verfahren können in Vakuumanlagen überall dort zum Einsatz kommen, wo plattenförmige Substrate einer thermischen Belastung ausgesetzt sind. Beispiele hierfür sind verschiedene Formen der Vakuumbeschichtung, Oberflächen-modifizierungen oder Formen einer gezielten thermischen Behandlung von Oberflächen im Vakuum.

Eine Kühlung zu behandelnder Substrate ist technologisch bedingt häufig erforderlich, wenn ohne Kühlung durch eine thermische Belastung eine Schädigung des Substrates durch Überhitzen zu erwarten ist oder sich ohne Kühlung eine Substrattemperatur einstellen würde, die einem angestrebten Effekt entgegensteht. Beispiele hierfür finden sich ebenfalls im Bereich der Vakuumbeschichtung. So werden häufig mit einer Beschichtung bestimmte strukturelle Eigenschaften der aufgebrachten Schicht angestrebt, die eine starke Abhängigkeit von der Temperatur des Substrates zeigen.

Da Kühlen durch Konvektion im Vakuum bei geringen Drücken eine geringe Rolle spielt und ein effektives Kühlen durch Wärmestrahlung erst bei Temperaturen erfolgt, die bei vielen Beschichtungsverfahren gerade vermieden werden sollen, liegt der Schwerpunkt einer Substratkühlung bei Vakuumprozessen auf einer Ableitung der eingetragenen Energie durch Wärmeleitung vom Ort des Energieeintrags in und durch das Substrat hindurch zu einem Kühlkörper. Die Effektivität einer solchen Kühlung hängt im Wesentlichen davon ab, wie effektiv der Wärmeübergang vom Substrat auf den Kühlkörper erfolgen kann.

Es ist bekannt, flache Substrate zu kühlen, indem ein durch eine Folie begrenzter Fluidraum an ein zu kühlendes Substrat angepresst wird (US 5,685,363). Der Wärmeübergang vom Substrat zum Fluid soll dabei durch Erhöhen des Anpressdruckes, beispielsweise durch Spiralfedern und durch Einsatz einer einen guten Wärmekontakt vermittelnden dünnen Folienbeilage optimiert werden. Die Folie dient dabei in erster Linie einem Ausgleich von Unebenheiten der sich berührenden Flächen. Der Wärmetransfer durch Folien hindurch erfolgt jedoch insgesamt bei vielen Anwendungen in ungenügendem Umfang.

Es ist weiterhin bekannt, zum Kühlen von Wafern deren Rückseite einer Kühlgasströmung auszusetzen (US 5,842,690). Der Druck des strömenden Kühlgases kann jedoch nicht besonders hoch gewählt werden, da ansonsten eine starke Ausbauchung der zu kühlenden Wafer zu erwarten wäre.

Es ist bekannt, Substrate mit hoher thermischer Belastung in CVD-Prozessen durch einen starken Gasstrom zu kühlen (US 4,913,090). Das ist möglich, da bei CVD-Prozessen ohnehin relativ hohe Drücke herrschen. Für PVD-Prozesse kommt dieses Verfahren nicht in Betracht, da die dort verwendeten Arbeitsdrücke in der Regel um mehrere Größenordnungen unter den für CVD-Anwendungen typischen Drücken liegen.

Es ist ebenfalls bekannt, durch Erhöhen des Anpressdruckes eines Kühlkörpers gegen ein zu kühlendes Substrat den Wärmeübergang zu verbessern (DE 43 03 398 A1). Dieser Methode sind dadurch Grenzen gesetzt, dass zum einen in den Bereichen, in denen das Substrat beschichtet werden soll, nur begrenzt Mittel zum Einsatz gebracht werden können, die den Anpressdruck erhöhen, zum anderen wird auch bei starker Zunahme des Anpressdruckes die Kontaktfläche nur geringfügig vergrößert, was im Wesentlichen durch mikrogeometrische Oberflächengegebenheiten erklärt werden kann.

Es ist weiterhin bekannt, die Oberfläche eines Kühlkörpers effektiv zu kühlen, indem im Inneren des Kühlkörpers eine Flüssigkeitskühlung vorgesehen ist (DE 197 08 341 A1). Dadurch erfolgt ein schneller Wärmetransport von der Oberfläche des Kühlkörpers in dessen Inneres. Die Effektivität des Wärmeübergangs vom zu kühlenden Substrat auf den Kühlkörper bleibt jedoch als limitierender Faktor bestehen.

Schließlich ist bekannt, den Wärmekontakt zwischen Substrat und Kühlkörper durch einen Spalt mit definierter Gasbefüllung zu vermitteln (EP 1 028 176 A1). Spaltgeometrie, Gasart und Gasdruck sind dabei die bestimmenden Parameter. Problematisch ist jedoch, dass der Gasdruck die Spaltgeometrie beeinflussen kann. Bewirkt ein zu hoher Gasdruck beispielsweise an einem zu kühlenden Wafer eine Ausbauchung, so hat dies eine ungleichmäßige Spaltbreite zur Folge, was gleichzeitig einen unterschiedlich effektiven Wärmeübergang von einzelnen Bereichen des Wafers zum Kühlkörper bedeutet. Eine größere Spaltbreite ist gleichzeitig mit einem schlechteren Wärmeübergang verbunden.

Der Erfindung liegt daher das technische Problem zugrunde ein Verfahren und eine Vorrichtung anzugeben, die eine gegenüber dem Stand der Technik verbesserte Kühlung plattenförmiger Substrate erlauben. Das Kühlverfahren soll vakuumtauglich sein und die vorgenannten Nachteile des Standes der Technik vermeiden.

Die Lösung des technischen Problems ergibt sich durch die Gegenstände mit den Merkmalen der Patentansprüche 1 und 15. Weitere vorteilhafte Ausgestaltungen der Erfindung ergeben sich aus den abhängigen Ansprüchen.

Die Erfindung geht davon aus, dass es zweckmäßig ist, zur Vermittlung des Wärmekontaktes zwischen einem zu kühlenden Substrat und einem Kühlkörper ein Fluid einzusetzen, welches mit mindestens einer Seite des Substrates und der Oberfläche des Kühlkörpers in direktem Kontakt steht. Der Wärmeübergang vom Substrat zum Kühlkörper erfolgt umso effektiver, je kleiner der Abstand zwischen Substrat und Kühlkörper und je höher der Druck des den Wärmekontakt vermittelnden Fluids ist.

Ein hoher Fluiddruck bewirkt eine hohe mechanische Belastung des Substrates, da das Substrat eine Trennfläche zwischen Fluid und Vakuum bildet und aus der Druckdifferenz resultierende Kräfte aufnehmen muss. Die Aufnahme dieser Kräfte erfolgt durch eine elastische Verformung des Substrates, wodurch den durch die Druckdifferenz bedingten Kräften entgegenwirkende Rückstellkräfte erzeugt werden.

Die zum Erzeugen von Rückstellkräften erforderliche Deformation des Substrates kann jedoch den Abstand zwischen Substrat und Kühlkörper nachteilig beeinflussen. Führt die Deformation zu ungleichmäßigen Abständen zwischen Substrat und Kühlkörper, so werden bei konstantem Fluiddruck Substratbereiche, die sich näher am Kühlkörper befinden, effektiver gekühlt als Bereiche, die sich in einem etwas größeren Abstand zum Kühlkörper befinden. Diese Ungleichmäßigkeit der abführbaren Wärmemenge tritt bei insgesamt geringen Abständen zwischen Substrat und Kühlkörper stärker hervor, so dass sich in diesem Fall bereits kleine absolute Änderungen des Abstandes als große relative Änderungen beim Wärmeübergang bemerkbar machen. Gerade die für einen effektiven Wärmeübergang vom Substrat zum Kühlkörper interessanten kleinen Abstände sind also vor dem Hintergrund einer möglichst gleichmäßigen Kühlung besonders kritisch, was ihre Konstanthaltung anbelangt. Da außerdem hohe Fluiddrücke für eine effektive Kühlung angestrebt werden sollten, ergeben sich weitere Anforderungen, die durch die erfindungsgemäße Lösung der Aufgabe erfüllt werden müssen.

Den bei hohen Fluiddrücken auf das Substrat einwirkenden Kräften müssen Rückstellkräfte entgegengesetzt werden, die ein Verändern der Spaltgeometrie verhindern. Demgemäß wird bei einer erfindungsgemäßen Vorrichtung und beim erfindungsgemäßen Verfahren den durch einen hohen Fluiddruck an einem plattenförmigen Substrat anliegenden Kräften durch eine mechanische Zwangsführung des Substrates entgegengewirkt.

Die Zwangsführung erfolgt derart, dass das Substrat durch mechanischen Druck elastisch verformt wird, wobei die durch die Verformung bewirkten Rückstellkräfte von den Mitteln erzeugt werden, die die Zwangsführung bewirken. Unter Mitteln, die eine Zwangsführung des Substrates bewirken, sind jegliche mechanische oder anders geartete Einrichtungen zu sehen, die das Substrat in einem zumindest teilweise elastisch deformierten Zustand fixieren. Die Zwangsführung des Substrates erfolgt in einer Weise, dass zwischen der Rückseite des Substrates und der Oberfläche des Kühlkörpers ein Spalt konstanter Breite ausgebildet wird. Dieser Spalt wird zur Kühlung des Substrates mit einem Fluid befüllt, welches einen guten Wärmekontakt zwischen Substrat und Kühlkörper vermittelt. Als Substratrückseite ist hierbei diejenige Seite eines plattenförmigen Substrates zu verstehen, die nicht einer Oberflächenbehandlung unterzogen werden soll.

Als mit einem Fluid befüllbarer Spalt zwischen einem Substrat und einer Kühlfläche ist im Erfindungssinn auch eine verbleibende Spaltgeometrie anzusehen, die entsteht, wenn das Substrat durch elastisches Verformen an die Kühlfläche gepresst wird. Vom Vorhandensein eines befüllbaren Zwischenraumes zwischen Substratrückseite und Kühlfläche kann grundsätzlich ausgegangen werden, auch wenn die Oberfläche/n von Substrat oder/und Kühlkörper dem menschlichen Empfinden nach glatt ausgeführt ist/sind.

Die Erfindung wird realisiert durch eine Vorrichtung und ein Verfahren zum Kühlen plattenförmiger Substrate im Vakuum, wobei mindestens eine kühlfläche einen Kühlkörper begrenzt, erste Mittel mindestens ein plattenförmiges Substrat auf der Kühlfläche des Kühlkörpers derart fixieren, dass die der Kühlfläche zugewandte Seite des Substrates im Wesentlichen parallel zur Kühlfläche verläuft und zweite Mittel ein Fluid in einen Zwischenraum zwischen Kühlfläche und Substrat zuführen, wobei die Form der Kühlfläche derart ausgebildet wird, dass eine im Wesentlichen parallele Anordnung der der Kühlfläche zugewandten Substratseite zur Kühlfläche nur durch eine zumindest teilweise elastische Verformung des Substrates mittels einer auf das Substrat einwirkenden Verformungskraft erreicht wird, die dem Betrag nach mindestens so groß ist, wie die durch den Druck des Fluids im Zwischenraum auf das Substrat einwirkende Kraft.

Es hat sich gezeigt, dass eine elastische Deformation eines Substrates, welche ausreichend hohe Rückstellkräfte erzeugt, mit vielen Vakuumbeschichtungsschritten oder Oberflächenbehandlungen kombiniert werden kann, ohne dass die anschließende Entspannung des Substrates nach Aufgabe der Zwangsführung die Qualität der Beschichtung oder das angestrebte technologische Ziel merklich beeinträchtigt.

Eine Kühlung lässt sich realisieren, wenn ein Fluiddruck von mindestens 100 Pa eingestellt wird. Ein besonders effektiver Druckbereich, bei dem eine sehr effektive Kühlung erfolgt und die zum Erzeugen der erforderlichen Rückstellkräfte erforderliche Deformation noch in einem Bereich liegt, in dem eine später vorzunehmende Entspannung des Substrates keine nennenswerten Schäden verursacht, liegt oberhalb von 500 Pa. Bei entsprechender Auslegung der Mittel zur Zwangsführung des Substrates lassen sich sogar Drücke oberhalb des Atmosphärendruckes realisieren.

Das erfindungsgemäße Verfahren kann sowohl mit flüssigen als auch gasförmigen Fluiden wie beispielsweise Wasserstoff ausgeführt werden. Wird mit einem Gas als Fluid gearbeitet, so ist ein geringes Molekulargewicht besonders vorteilhaft. Werden die vakuumtechnolgischen Prozesse zum Beschichten eines Substrates unter Beteiligung eines Reaktivgases und/oder eines Inertgases ausgeführt, kann es vorteilhaft sein, eine dieser gasförmigen Komponenten gleichzeitig als den Wärmekontakt zwischen Substrat und Kühlkörper vermittelndes Fluid einzusetzen. Die Anforderungen an die Abdichtung des Zwischenraumes zwischen Substrat und Kühlkörper, der zumindest gegenüber dem Vakuum des Prozessraumes unter Überdruck steht, sind dann wesentlich geringer. Geringe Mengen austretenden Fluids stellen dann auch keine Verunreinigungen im Prozessraum dar. Aus der Gruppe der Reaktivgase können beispielsweise Sauerstoff oder Stickstoff als Fluid verwendet werden. Bei Inertgasen sind beispielsweise Helium und Argon als Fluid einsetzbar.

Bei einer besonders vorteilhaften Ausführungsform der Erfindung dient Luft als Fluid. Hierbei wird beispielsweise ein Substrat außerhalb einer Vakuumbearbeitungskammer bei Atmosphärendruck auf einen Kühlkörper gespannt. Die dabei zwischen Substrat und Kühlkörper eingeschlossene Luft dient dann als den Wärmekontakt zwischen Substrat und Kühlkörper vermittelndes Fluid. Anschließend wird der Kühlkörper mit Substrat zum Beschichten in die Vakuumarbeitskammer eingebracht. Dass der Druck der Luft im Spalt zwischen Substrat und Kühlkörper während des Beschichtungsvorgangs nicht immer konstant ist und vom Atmosphärendruck abweichen kann, ist unerheblich für das erfindungsgemäße Verfahren. Der Vorteil dieser Ausführungsform ergibt sich aus dem vereinfachten Aufbau wegen des Wegfalls eines Fluidleitsystems innerhalb der Vakuumarbeitskammer.

Eine weitere Steigerung der Effektivität des erfindungsgemäßen Verfahrens lässt sich realisieren, wenn während des Kühlvorganges das Fluid den Zwischenraum zwischen Kühlfläche und parallel angeordneter Substratrückseite zumindest teilweise und/oder zeitweise durchströmt. Auf diese Weise wird zusätzlich zur Vermittlung einesguten Wärmekontaktes zwischen Substrat und Kühlkörper die Wärmekapazität des abströmenden Fluids für die Substratkühlung genutzt.

Vorrichtungen zum Ausführen des erfindungsgemäßen Verfahrens zum rückseitigen Kühlen elastischer Substrate im Vakuum umfassen mindestens eine Kühlfläche als Begrenzung eines Kühlkörpers, Mittel zum Fixieren mindestens eines Substrates derart, dass die Rückseite des Substrates im Wesentlichen parallel zur Kühlfläche verläuft und Mittel zum Zuführen eines Fluids in einen Zwischenraum zwischen Kühlfläche und Substratrückseite, wobei die Form der Kühlfläche derart ausgebildet ist, dass eine im Wesentlichen parallele Anordnung der Substratrückseite zur Kühlfläche nur durch eine zumindest teilweise elastische Verformung des Substrates mittels einer auf das Substrat einwirkenden Verformungskraft erreicht werden kann, die dem Betrag nach mindestens so groß ist, wie die durch den Druck des Fluids auf das Substrat einwirkende Kraft.

Zweckmäßigerweise umfasst die Kühlfläche Bohrungen zum Zuführen eines Fluids in den Zwischenraum zwischen Kühlfläche und Substratrückseite durch die Kühlfläche hindurch, durch die eine Fluidzufuhr oder/und eine Fluidabfuhr erfolgen kann. Bei sehr geringen Spaltbreiten zwischen Kühlkörper und Substrat lassen sich allein durch den Strömungswiderstand, den der enge Spalt einem einströmenden Fluid entgegensetzt, bei mäßiger Belastung des Vakuums Fluiddrücke realisieren, die für eine erfindungsgemäße Kühlung geeignet sind. Besonders vorteilhafte Ausführungsformen umfassen jedoch Dichtmittel, die den Zwischenraum zwischen Kühlfläche und Substratrückseite zum Vakuum hin abdichten.

Dadurch kommt es auch bei vergleichsweise hohen Fluiddrücken zu keiner Belastung des Prozessvakuums. Die ausgewählten Dichtmittel hängen jeweils von den ausgewählten Druckbereichen, dem Saugvermögen des Vakuumsystems und möglicherweise weiteren technologischen Randbedingungen ab. Bewährt haben sich Dichtungen aus Gummi, Viton oder weiteren elastischen Materialien. Bewährt haben sich ebenfalls Schneidkantendichtungen.

Vorteilhaft kann es sein, wenn die Dichtmittel Mittel zum Zuführen eines Fluids in den Zwischenraum zwischen Kühlfläche und Substratrückseite enthalten. Dadurch ist die erfindungsgemäße Vorrichtung leicht in bestehende Vakuumanlagen zu integrieren, ohne dass dort bereits vorhandene Kühlflächen durchbohrt werden müssen. Mit Vorteil kann die Abdichtung des mit Fluid gefüllten Raumes zum Vakuum hin in mehreren Druckstufen erfolgen. Dabei können die Dichtmittel mindestens einen abpumpbaren Bereich umfassen, in welchem ein Druck einstellbar ist, der zwischen dem Druck des Fluids und dem Vakuumdruck liegt. Soll die Kühlung durch eine Fluidströmung intensiviert werden, so müssen zusätzlich Mittel zum Abpumpen des Fluids aus dem Zwischenraum zwischen Kühlfläche und Substratrückseite vorhanden sein.

Eine besonders vorteilhafte Realisierung der erfindungsgemäßen Zwangsführung des Substrates ergibt sich, wenn Mittel vorhanden sind, mit denen ein Anpressen des Substrates an eine beispielsweise konvexe Kühlfläche erfolgen kann. Besonders vorteilhaft ist dabei, wenn die Mittel zum Anpressen des Substrates nur in Randbereichen des Substrates angreifen.

Eine besonders einfache Ausführungsform ergibt sich, wenn der durch die Kühlfläche begrenzte Kühlkörper so ausgeführt ist, dass er sich bei einer vorgesehenen thermischen Belastung durch eine ausreichend hohe Wärmekapazität nur langsam erwärmt. Es kann jedoch auch vorteilhaft sein, den durch die Kühlfläche begrenzten Kühlkörper so auszugestalten, dass er selbst durch ein ihn durchströmendes Kühlmedium gekühlt werden kann.

Bei einigen Ausführungsformen kann es vorteilhaft sein, wenn der Abstand zwischen Kühlfläche und Substratrückseite durch Anschlagmittel festgelegt ist. Besonders vorteilhaft ist es dabei, wenn als Anschlagmittel austauschbare Abstandhalter vorgesehen sind. In diesem Fall kann die Spaltbreite auf einfache Weise an erforderliche Kühlleistungen angepasst werden. Eine vorteilhafte Ausführungsform ergibt sich, wenn als Anschlagmittel Dichtmittel, die den Zwischenraum zwischen Kühlfläche und Substratrückseite zum Vakuum hin abdichten, dienen.

Besonders vorteilhaft ist es, wenn die Kühlfläche derart profiliert ausgeführt ist, dass einzelne erhabene Flächenbereiche als Abstandhalter fungieren. In diesem Sinne kann auch eine technisch bedingte oder gezielt eingestellte Rauhigkeit der Kühlfläche bei Anpressen eines zu kühlenden Substrates einerseits für eine ausreichend definierte Abstützung des Substrates sorgen und andererseits genügend fluidgefülltes Volumen bereitstellen, um das erfindungsgemäße Verfahren ausführen zu können.

Die Erfindung wird nachfolgend anhand bevorzugter Ausführungsbeispiele näher erläutert. Die Fig. zeigen:
- Fig. 1: eine schematische Schnittdarstellung einer Vorrichtung mit konvexer Kühlfläche zum Durchführen des erfindungsgemäßen Verfahrens,
- Fig. 2: eine schematische Schnittdarstellung einer Vorrichtung mit konkaver Kühlfläche zum Durchführen des erfindungsgemäßen Verfahrens.

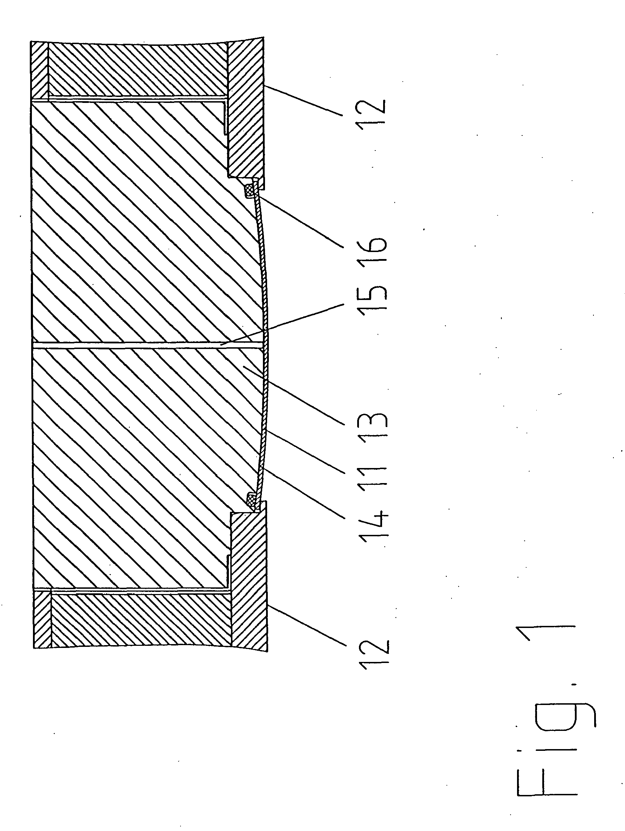

Fig. 1 Ein ebenes plattenförmiges Substrat 11 aus 2 mm Stahlblech soll auf einer Seite mittels eines Vakuumprozesses innerhalb einer nicht dargestellten Prozesskammer beschichtet werden. Zum Erlangen optimaler Schichteigenschaften ist es erforderlich das Substrat 11 während des Beschichtungsvorgangs zu kühlen. Dazu wird das Substrat 11 mit der nicht zu beschichtenden Seite mittels einer Andruckplatte 12 gegen die konvexe Fläche eines massiven Kühlkörpers 13 gepresst. Dabei steht das Substrat 11 nur an dessen Rändern in Kontakt zur Andruckplatte 12, liegt jedoch flächig an der konvexen Fläche an. Die konvexe Fläche ist dabei derart geformt, dass diese weitgehend der Biegelinie des Substrates 11 entspricht und somit ein flächiges Anliegen des Substrates 11 am Kühlkörper 13 ermöglicht.

Obwohl das Substrat 11 flächig an der Oberfläche des Kühlkörpers 13 anliegt, entsteht zwischen Substrat 11 und Kühlkörper 13 ein Spalt 14. Selbst bei glatten Oberflächen von Substrat und Kühlkörper entsteht aufgrund mikrogeometrischer Oberflächengegebenheiten ein Spalt, der hinreichend für das Ausführen des erfindungsgemäßen Verfahrens ist.

Durch den Kühlkörper hindurch verläuft ein Kanal 15, durch den ein gasförmiges Fluid in den Spalt 14 zwischen Substrat 13 und Kühlkörper 11 eingelassen werden kann. Als Fluid wird im Ausführungsbeispiel Helium verwendet. Trotz des flächigen Kontaktes zwischen Substrat 11 und Kühlkörper 13 bildet sich so in mikroskopisch kleinen Hohlräumen, die durch die Oberflächenrauhigkeit von Substrat 11 und Kühlkörper 13 bedingt sind, ein Fluidpolster, das erfindungsgemäß einen ausreichenden Wärmekontakt zwischen Substrat 11 und Kühlkörper 13 vermittelt. Seitlich begrenzt wird das Fluidpolster durch eine umlaufende Dichtung 16, welche verhindert, dass das Fluid aus dem Spalt 14 in die Prozesskammer entweicht.

Die von der Andruckplatte 12 auf das Substrat 11 übertragene Kraft bewirkt ein flächiges Anliegen des Substrates 11 an der Oberfläche des Kühlkörpers 13 und somit das Ausbilden des Spaltes 14 mit einer gleichmäßigen Spaltbreite. Dies gewährleistet ein gleichmäßiges Kühlen des Substrates 11 auf der gesamten zu beschichtenden Oberfläche während des Beschichtungsvorganges. Da die Verformungskraft, die mittels Andruckplatte 12 auf das Substrat 11 übertragen wird, stets mindestens genauso groß ist wie die Kraft, die durch den Fluiddruck im Spalt 14 auf das Substrat 11 ausgeübt wird, verändert sich die Spaltgeometrie während des Beschichtungsvorganges nicht.

Überraschende Ergebnisse wurden bei einer Versuchsanordnung erzielt, bei der der Kühlkörper 13 keine Bohrung 15 aufwies. Unter Atmosphärendruck wurde das Substrat 11 mittels der Andruckplatte 12 an den konvexen Kühlkörper 13 gepresst. Die dabei unter Atmosphärendruck im Spalt 14 eingeschlossene Luft war dabei ein hinreichendes Fluid, um den Wärmeleitübergang zwischen Substrat 11 und Kühlkörper 13 herzustellen und somit während des gesamten Beschichtungsvorgangs eine gleichmäßige und ausreichende Kühlung zu gewährleisten.

Überraschend sind diese Ergebnisse deshalb zu bezeichnen, weil der Spalt 14 während des Beschichtungsvorganges ein abgeschlossenes Volumen darstellt, in welchem kein Druckausgleich durchgeführt werden kann, wie bei Verwendung eines Kühlkörpers mit Bohrung und einer somit bestehenden Möglichkeit eine Druckregulierung im Spalt 14 vorzunehmen. Die ansteigende Temperatur des Substrates 11 während des Beschichtungsvorganges bewirkt auch ein Ansteigen des Druckes der Luft im Spalt 14 über der Atmosphärendruck hinaus. Dennoch konnte aufgrund der mit dieser Versuchsanordnung erzielten Beschichtungsqualität davon ausgegangen werden, dass trotz ansteigenden Druckes im Spalt 14 eine gleich bleibende Spaltgeometrie durch die Zwangsführung des Substrates 11 aufrechterhalten werden konnte.

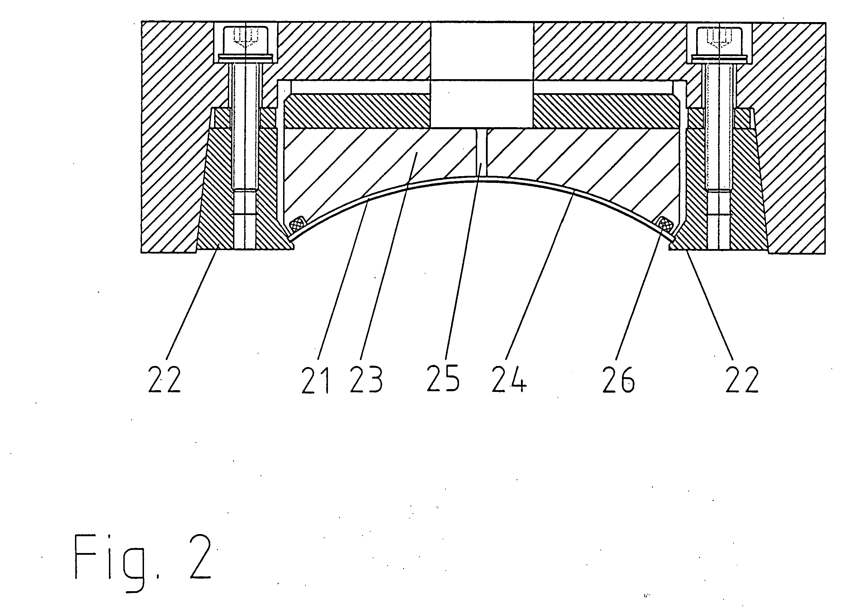

In Fig. 2 ist schematisch eine alternative erfindungsgemäße Vorrichtung dargestellt, mittels derer ein 2 mm starkes, ebenes, plattenförmiges Substrat 21, bestehend aus zwei Lagen verschiedener Metalllegierungen, auf einer Seite, welche durch die Art der Metalllegierung bestimmt ist, beschichtet werden soll. Dazu wird das Substrat 21 mit der nicht zu beschichtenden Seite mittels einer Andruckplatte 22 flächig gegen die konkave Oberfläche eines Kühlkörpers 23 gepresst. Die dabei entstehende Verformung des Substrates 21 wird nachfolgend konkave Verformung, Bezug nehmend auf die konkave Kühlkörperoberfläche, genannt. Trotz flächigen Anpressens bildet sich zwischen Substrat 21 und Kühlkörper 23 im Erfindungssinn ein Spalt 24 mit gleich bleibender Spaltbreite aus, der über eine durch den Kühlkörper 23 führende Bohrung 25 mit einem Fluid befüllt wird. Das Ausbilden des Spaltes 24 mit gleich bleibender Spaltbreite wird dadurch begünstigt, indem die konkave Oberflächenform des Kühlkörpers 23 der Biegelinie des Substrates 21 angepasst wurde.

Auch bei dieser Aufgabenstellung wurden Versuche mit einer konvexen Kühlkörperoberfläche durchgeführt, welche jedoch nicht zu einem gewünschten Kühlverhalten führten. Vermutet wurde hierbei, dass aufgrund des zweilagigen Substrates, bestehend aus zwei verschiedenen Metalllegierungen, während des Beschichtungsvorgangs auf dem Bimetalleffekt beruhende Verformungskräfte, die der konvexen Verformung entgegenwirken, zu einer ungleichmäßigen Veränderung der Spaltgeometrie und somit zu einem ungleichmäßigen Kühlverhalten während des Beschichtungsvorgangs führen. Dieser Vermutung entsprechend wirken die Bimetall-Verformungskräfte bei dieser Aufgabenstellung in Richtung konkaver Verformung des Substrates 21 und unterstützen somit das flächige Anpressen des Substrats 21 an die konkave Oberfläche des Kühlkörpers 23.

## Patentansprüche

1. Vorrichtung zum Kühlen plattenförmiger Substrate im Vakuum, umfassend mindestens eine Kühlfläche als Begrenzung eines Kühlkörpers (13), erste Mittel (12) zum Fixieren mindestens eines plattenförmigen Substrates (11) auf der Kühlfläche des Kühlkörpers (13) derart, dass die der Kühlfläche zugewandte Seite des Substrates (11) im Wesentlichen parallel zur Kühlfläche verläuft und zweite Mittel zum Zuführen eines Fluids in einen Zwischenraum (14) zwischen Kühlfläche und Substrat (11), **dadurch gekennzeichnet, dass** die Form der Kühlfläche derart ausgebildet ist, dass eine im Wesentlichen parallele Anordnung der der Kühlfläche zugewandten Substratseite nur durch eine zumindest teilweise elastische Verformung des Substrates (11) mittels einer auf das Substrat einwirkenden Verformungskraft erreichbar ist, die dem Betrag nach mindestens so groß ist, wie die durch den Druck des Fluids im Zwischenraum (14) auf das Substrat (11) einwirkende Kraft.

2. Vorrichtung nach Anspruch 1, **dadurch gekennzeichnet, dass** die zweiten Mittel zum Zuführen des Fluids in den Zwischenraum (14) zwischen Kühlfläche und Substrat (11) mindestens eine Bohrung (15) durch den Kühlkörper (13) umfassen, durch die ein Fluid in den Zwischenraum (14) zuführbar ist.

3. Vorrichtung nach Anspruch 1 oder 2, **dadurch gekennzeichnet, dass** Dichtmittel (16) vorhanden sind, die den Zwischenraum (14) zwischen kühlfläche und Substrat (11) zum Vakuum hin abdichten.

4. Vorrichtung nach Anspruch 3, **dadurch gekennzeichnet, dass** die Dichtmittel Mittel zum Zuführen des Fluids in den Zwischenraum (14) zwischen Kühlfläche und Substrat (11) enthalten.

5. Vorrichtung nach Anspruch 3 oder 4, **dadurch gekennzeichnet, dass** die Dichtmittel mindestens einen abpumpbaren Bereich umfassen, in welchem ein Druck einstellbar ist, der zwischen dem Druck des Fluids und dem Vakuumdruck liegt.

6. Vorrichtung nach einem der vorhergehenden Ansprüche, **dadurch gekennzeichnet, dass** Mittel zum Abpumpen des Fluids aus dem Zwischenraum (14) zwischen Kühlfläche und Substrat (11) vorhanden sind.

7. Vorrichtung nach einem der vorhergehenden Ansprüche, **dadurch gekennzeichnet, dass** Mittel (12; 22) vorhanden sind, mit denen das Substrat (11) an eine konvexe oder konkave Kühlfläche anpressbar ist.

8. Vorrichtung nach Anspruch 7, **dadurch gekennzeichnet, dass** die Mittel (12; 22) zum Anpressen des Substrates (11; 21) derart ausgebildet sind, dass diese nur in Randbereichen des Substrates (11; 21) angreifen.

9. Vorrichtung nach einem der vorhergehenden Ansprüche, **dadurch gekennzeichnet, dass** der durch die Kühlfläche begrenzte Kühlkörper (13) derart ausgebildet ist, dass sich dieser bei einer vorgesehenen thermischen Belastung durch eine ausreichend hohe Wärmekapazität nur langsam erwärmt.

10. Vorrichtung nach einem der vorhergehenden Ansprüche, **dadurch gekennzeichnet, dass** der durch die Kühlfläche begrenzte Kühlkörper (13) derart ausgebildet ist, dass dieser selbst mittels eines Kühlmediums kühlbar ist.

11. Vorrichtung nach einem der vorhergehenden Ansprüche, **dadurch gekennzeichnet, dass** der Abstand zwischen Kühlfläche und Substrat durch Anschlagmittel festgelegt ist.

12. Vorrichtung nach Anspruch 11, **dadurch gekennzeichnet, dass** als Anschlagmittel austauschbare Abstandhalter verwendbar sind.

13. Vorrichtung nach Anspruch 11, **dadurch gekennzeichnet, dass** als Anschlagmittel Dichtmittel, die den Zwischenraum zwischen Kühlfläche und Substratrückseite zum Vakuum hin abdichten, verwendbar sind.

14. Vorrichtung nach einem der vorhergehenden Ansprüche, **dadurch gekennzeichnet, dass** die Kühlfläche derart profiliert ausgeführt ist, dass einzelne erhabene Flächenbereiche als Abstandhalter fungieren.

15. Verfahren zum Kühlen plattenförmiger Substrate im Vakuum, wobei mindestens eine Kühlfläche einen Kühlkörper (13) begrenzt, erste Mittel (12) mindestens ein plattenförmiges Substrat (11) auf der Kühlfläche des Kühlkörpers (13) derart fixieren, dass die der Kühlfläche zugewandte Seite des Substrates (11) im Wesentlichen parallel zur Kühlfläche verläuft und zweite Mittel ein Fluid in einen Zwischenraum (14) zwischen Kühlfläche und Substrat (11) zuführen, **dadurch gekennzeichnet, dass** die Form der Kühlfläche derart ausgebildet wird, dass eine im Wesentlichen parallele Anordnung der der Kühlfläche zugewandten Substratseite zur Kühlfläche nur durch eine zumindest teilweise elastische Verformung des Substrates (11) mittels einer auf das Substrat(11)einwirkenden Verformungskraft erreicht wird, die dem Betrag nach mindestens so groß ist wie die durch den Druck des Fluids im Zwischenraum (14) auf das Substrat (11) einwirkende Kraft.

16. Verfahren nach Anspruch 15, **dadurch gekennzeichnet, dass** ein Fluiddruck von mindestens 100 Pa im Zwischenraum (14) eingestellt wird.

17. Verfahren nach Anspruch 16, **dadurch gekennzeichnet, dass** ein Fluiddruck von mindestens 500 Pa im Zwischenraum (14) eingestellt wird.

18. Verfahren nach Anspruch 17, **dadurch gekenhzeichnet, dass** im Zwischenraum (14) ein Fluiddruck eingestellt wird, der dem Atmosphärendruck entspricht.

19. Verfahren nach einem der Ansprüche 15 bis 18, **dadurch gekennzeichnet, dass** eine Flüssigkeit als Fluid verwendet wird.

20. Verfahren nach einem der Ansprüche 15 bis 18, **dadurch gekennzeichnet, dass** ein Gas oder Gasgemisch als Fluid verwendet wird.

21. Verfahren nach Anspruch 20, **dadurch gekennzeichnet, dass** ein Reaktivgas als Fluid verwendet wird.

22. Verfahren nach Anspruch 21, **dadurch gekennzeichnet, dass** Sauerstoff oder Stickstoff als Fluid verwendet wird.

23. Verfahren nach Anspruch 20, **dadurch gekennzeichnet, dass** ein Inertgas als Fluid verwendet wird.

24. Verfahren nach Anspruch 23, **dadurch gekennzeichnet, dass** Helium oder Argon als Fluid verwendet wird.

25. Verfahren nach Anspruch 20, **dadurch gekennzeichnet, dass** Wasserstoff als Fluid verwendet wird.

26. Verfahren nach Anspruch 20, **dadurch gekennzeichnet, dass** Luft als Fluid verwendet wird.

27. Verfahren nach einem der Ansprüche 15 bis 26, **dadurch gekennzeichnet, dass** während des Kühlvorganges das Fluid den Zwischenraum (14) zwischen Kühlfläche und parallel angeordneter Substratseite zumindest teilweise und/oder zeitweise durchströmt.
